Europäisches Patentamt

European Patent Office

Office européen des brevets

(11) Veröffentlichungsnummer: **0 271 849 B1**

# EUROPÄISCHE PATENTSCHRIFT

(45) Veröffentlichungstag der Patentschrift: **15.09.93**

(51) Int. Cl.5: **G01R 27/02**, G01N 27/22

(21) Anmeldenummer: **87118435.4**

(22) Anmeldetag: **12.12.87**

(54) **Impedanzmessgerät zur Bestimmung der durch Eintauchen in eine Flüssigkeit veränderlichen Impedanz eines kapazitiven Sensors.**

(30) Priorität: **19.12.86 DE 3643389**

(43) Veröffentlichungstag der Anmeldung:
**22.06.88 Patentblatt 88/25**

(45) Bekanntmachung des Hinweises auf die
Patenterteilung:
**15.09.93 Patentblatt 93/37**

(84) Benannte Vertragsstaaten:
**DE ES FR GB IT SE**

(56) Entgegenhaltungen:
**EP-A- 0 080 632**
**WO-A-85/04718**
**US-A- 3 786 349**
**US-A- 4 342 089**

**E. Scrüfer, Elektrische Messtechnik, S. 315-316**

(73) Patentinhaber: **DODUCO KG. Dr. Eugen Dürr-wächter**
**Im Altgefäll 12**
**D-75181 Pforzheim(DE)**

(72) Erfinder: **Normann, Norbert, Dr, Dipl.-Phys.**
**Westendstrasse 3**
**D-7530 Pforzheim(DE)**
Erfinder: **Schulze, Gunter, Dipl.-Ing.**
**Lutherstrasse 3**
**D-7536 Ispringen(DE)**
Erfinder: **Uhl, Günter, Dr., Dipl.-Ing.**
**Landhausstrasse 45**
**D-7267 Unterreichenbach(DE)**

(74) Vertreter: **Twelmeier, Ulrich, Dipl.Phys. et al**
**Westliche Karl-Friedrich-Strasse 29-31**
**D-75172 Pforzheim (DE)**

**Beschreibung**

Die Erfindung geht aus von einem Impedanzmeßgerät zur Bestimmung der durch Eintauchen in eine Flüssigkeit, deren Zustand zu überwachen ist, veränderlichen Impedanz eines Kapazitiven Sensors mit den im Oberbegriff des Anspruchs 1 angegebenen Merkmalen.

Ein derartiges Meßgerät ist ans der WO-A-8 504 718 bekannt.

Es sind Impedanzmeßgeräte bekannt, die zur Bestimmung des Wirkwiderstandes eines Meßobjektes eine Brückenschaltung verwenden oder nach einem Kompensationsverfahren arbeiten, und die den Blindwiderstand des Meßobjektes mittels einer Messung der Phasenverschiebung zwischen Strom und Spannung am Meßobjekt bestimmen, wobei die Phasenwinkelmessung mittels eines Quotientenmeßwerkes, mittels eines Phasendiskriminators, oder unmittelbar durch eine Messung des zeitlichen Abstandes zwischen einem Nulldurchgang der Stromstärke und dem nächsten Nulldurchgang der Spannung am Meßobjekt bei vorgegebener Frequenz erfolgt. Dabei kommt die sinusförmige elektrische Wechselspannung, welche dem Meßobjekt als Meßsignal eingespeist wird, üblicherweise aus einem Sinusgenerator, bei dem die Wahl zwischen einigen fest eingestellten Frequenzen des Meßsignals möglich ist. Die bekannten Impedanzmeßgeräte sind in der Lage, Impedanzen recht genau zu bestimmen; die Meßverfahren, nach denen sie arbeiten, sind jedoch verhältnismässig aufwendig und die Impedanzmeßgeräte deshalb ebenso aufwendig und teuer, so dass sie sich vor allem für den Laborbetrieb eignen, aber nicht zur Signalauswertung von Sensoren mit variabler Impedanz.

Der Erfindung liegt die Aufgabe zugrunde, eine Schaltungsanordnung für ein Impedanzmeßgerät anzugeben, welches sich so preiswert herstellen läßt, dass es sich für die Fertigung in großen Stückzahlen sowie für den Einsatz in industriellen Massenerzeugnissen eignet, und zwar als ein Mittel zur Signalauswertung von Sensoren, die zum Zwecke der Steuerung von Verfahrensabläufen oder zur Überwachung von Zuständen auf die veränderliche Impedanz eines Meßobjektes ansprechen, eignet.

Diese Aufgabe wird gelöst durch ein Impedanzmeßgerät mit den im Anspruch 1 angegebenen Merkmalen. Vorteilhafte Weiterbildungen der Erfindung sind Gegenstand der Unteransprüche.

Das erfindungsgemäße Impedanzmeßgerät verwendet als Signalquelle, die ein Meßsignal in das zu untersuchende Meßobjekt speist, einen digitalen Sinusgenerator, in welchem eine sinusförmige Wechselspannung dadurch erzeugt wird, dass die Periode des Sinussignals in eine vorgegebenen Anzahl von äquidistanten Stützstellen unterteilt und die Sinusform durch einen Polygonzug mit von Stützstelle zu Stützstelle konstanten Momentanwerten nachgebildet wird, welche in einem Speicher des Sinusgenerators auf Speicherplätzen gespeichert sind, die mit Hilfe einer entsprechenden Adressierung den jeweiligen Stützstellen zugeordnet sind. Die Momentanwerte werden aus dem Speicher zyklisch ausgelesen und einem Digital-zu-Analog-Wandler zugeführt, der daraus eine elektrische Schwingung in Form eines Polygonzuges bildet, deren Augenblickswerte den gespeicherten Momentanwerten proportional sind. Zur Glättung des Sinussignals und zum Unterdrücken von Oberwellen ist dem Digital-zu-Analog-Wandler zweckmässigerweise ein Tiefpaßfilter nachgeschaltet.

Ein digitaler Sinusgenerator, bei dem die Frequenz des Sinussignals nur stufenweise geändert werden kann, ist aus der DE-Z "Elektronik", Heft 17, 1983, Seiten 51 und 52 bekannt. Ein digitaler Sinusgenerator, bei dem die Frequenz des Sinussignals kontinuierlich geändert werden kann, ist in der deutschen Patentanmeldung P 36 43 389.6 beschrieben.

In dem erfindungsgemäßen Impedanzmeßgerät speist der digitale Sinusgenerator einen Sensor, dessen Impedanz es zu bestimmen gilt, mit einem Meßsignal, und zur Auswertung des elektrischen Antwortsignals, das durch den Durchlauf des Meßsignals durch den Sensor erhalten wird, ist eine Auswerteschaltung vorgesehen, die als wesentlichen Bestandteil eine digital arbeitende Meß-und Rechenschaltung, vorzugsweise einen Mikroprozessor, umfaßt, die durch ein gemeinsames Taktsignal mit dem Sinusgenerator synchronisiert ist. Dadurch ist eine starre zeitliche Kopplung zwischen dem Sinusgenerator als Quelle für das Meßsignal und der Auswerteschaltung gegeben, die die Signalauswertung sehr erleichtert.

Zur Ermittlung des Wirkwiderstandes des Sensors ist im Impedanzgerät ein Strom/Spannungswandler vorgesehen, dem das vom Sensor kommende Antwortsignal zugeführt wird und dessen Ausgangsspannung der Stromstärke des Antwortsignals proportional ist. Das Verhältnis der Amplitude des Meßsignals zur Amplitude der Ausgangsspannung des Strom/Spannungswandlers ist dem Wirkwiderstand des Sensors proportional; zur Bestimmung dieses Verhältnisses ist im Impedanzmeßgerät eine Amplitudenvergleichsschaltung vorgesehen, welcher sowohl das Meßsignal als auch das Ausgangssignal des Strom/Spannungswandlers zugeführt werden und in welcher die Amplituden dieser beiden Signale bestimmt werden und das Amplitudenverhältnis gebildet wird. Zu diesem Zweck kann man zwei Wechselspannungs/Gleichspannungswandler vorsehen, die das Meßsignal und das Ausgangssignal des Strom/Spannungswandlers jeweils in ein Gleichspannungssignal umwandeln; diese beiden Gleichspannungssignale speist man zweckmässigerweise in einen Analog/Digitalwandler ein, der das Verhältnis dieser beiden Gleichspannungssignale bildet. Der Analog/Digitalwandler ist vorzugsweise Teil des Mikroprozessors der Auswerteschaltung. Ist der Analog/Digitalwandler schnell genug, dann ist ein besonders vorteilhafter Aufbau der Auswerteschaltung moglich: Es kann dann nämlich auf die beiden Wechselspannungs/Gleichspannungswandler verzichtet werden. Vielmehr können das Meßsignal und das Ausgangssignal des Strom/Spannungswandlers dem Analog-zu-Digital-Wandler direkt eingespeist werden. Weil der Sinusgenerator und die Auswerteschaltung durch denselben Systemtakt synchronisiert sind, ist in Bezug auf den Systemtakt bekannt, wann der Spitzenwert des Meßsignals und der Spitzenwert des Ausgangssignals des Strom/Spannungswandlers am Eingang des Analog-zu-Digital-Wandlers auftreten, so dass der Analog-zu-Digital-Wandler die Spitzenwerte zeitgerecht abtasten, damit direkt bestimmen und bis zur Quotientenbildung halten kann. Sicherheitshalber empfiehlt es sich, nicht nur die Spitzenwerte der beiden Wechselspannungssignale abzutasten, sondern mehrere Messungen in der Nachbarschaft des jeweiligen Spitzenwertes vorzunehmen, vorzugsweise ungefähr drei Messungen um den Spitzenwert herum, aus denen man ohne Einbuße an Messgenauigkeit vor der Quotientenbildung einen Mittelwert bilden kann.

Zur Bestimmung der Phasenverschiebung zwischen dem Meßsignal und dem Antwortsignal des Strom/Spannungswandlers enthält das Impedanzmeßgerät zwei Nulldurchgangsdetektoren. Dem einen Nulldurchgangsdetektor wird das Meßsignal, dem anderen Nulldurchgangsdetektor das Ausgangssignal des Strom/Spannungswandlers zugeführt. Die Nulldurchgangsdetektoren haben digitale Ausgangssignale, deren Flanken zeitgleich mit den Nulldurchgängen des Meßsignales bzw. des Ausgangssignales des Strom/Spannungswandlers liegen. Auf ihnen läßt sich leicht der zeitliche Abstand der Nulldurchgänge der beiden Signale bestimmen, beispielsweise dadurch, dass die Meß- und Rechenschaltung einen Zähler enthält, der durch eine ausgewählte Flanke des vom Meßsignal abgeleiteten digitalen Nulldurchgangssignal gestartet und von der nächsten Flanke des anderen digitalen Nulldurchgangssignals gestoppt wird. Aus dem so ermittelten zeitlichen Abstand zwischen den Nulldurchgängen errechnet die Meß- und Rechenschaltung unter Berücksichtigung der bekannten Frequenz des Meßsignals die Phasenverschiebung zwischen dem Meßsignal und dem Ausgangssignal des Strom/Spannungswandlers und errechnet daraus ferner die Blindkomponente der Impedanz des Meßobjektes.

Ein Vorteil der mit einem schnellen Analog-zu-Digital-Wandler arbeitenden Auswerteschaltung liegt darin, dass eine dem Meßsignal überlagerte Gleichspannung, die durch den Sinusgenerator oder durch die Auswerteschaltung hervorgerufen sein kann, die Messung des Wirkwiderstandes nicht beeinflussen muss, da sich die überlagerte Gleichspannung durch die Meß- und Rechenschaltung leicht rechnerisch kompensieren läßt.

Das erfindungsgemäße Impedanzmeßgerät kann ausserordentlich kompakt aufgebaut werden. Nach dem heutigen Stand der Entwicklung auf dem Gebiet der kundenspezifischen integrierten Schaltkreise (sogenannte ASIC's) ist es möglich, nahezu die gesamte Schaltung einschließlich Mikrocomputer und analoge Schaltungen auf ein oder zwei Chips zu integrieren, wobei nur noch wenige zusätzliche diskrete Bauteile wie Widerstände und Kondensatoren benötigt werden. Der beschriebene Schaltungsaufbau erfordert keinerlei Abgleicharbeiten. Damit ist es möglich, das Impedanzmeßgerät in großer Anzahl kostengünstig herzustellen. Insbesondere kann es gemeinsam mit einem Sensor, der auf variable Impedanzen anspricht, in einem kleinen Gehäuse untergebracht werden.

Weitere Vorteile bestehen darin, dass das Impedanzmeßgerät ein digitales Meßverfahren anwendet: Sowohl die Erzeugung des Meßsignals als auch die Signalauswertung erfolgen im wesentlichen digital. Dabei ist die Messung in einem großen Frequenzbereich möglich. Auch wenn das Verhältnis von kleinster Frequenz zu größter Frequenz 1:1000 ist, dann läßt sich noch eine Meßgenauigkeit in der Größenordnung von 1 % erreichen. Ein weiterer Vorteil liegt darin, dass die Impedanzmessung unabhängig von einer genauen Referenzimpedanz erfolgen kann, denn wenn eine Drift des Meßsignals (Wechselspannungssignal) auftritt, dann tritt im Antwortsignal (der durch den Sensor fließende Wechselstrom) eine entsprechende Drift auf, da beide aus derselben Quelle stammen, und weil in der Auswerteschaltung das Wechselspannungssignal und das Wechselstromsignal zur Verhältnisbildung herangezogen werden, macht sich im Verhältnis die in beiden Signalen gleichermaßen auftretende Drift nicht bemerkbar. Deshalb ist auch eine Temperaturabhängigkeit der Meßgenauigkeit kaum vorhanden, weil der Temperatureinfluß sich überwiegend in der die Meßgenauigkeit nicht beeinträchtigenden gleichmässigen Drift äußert.

Die kompakte Bauweise und die digitale Signalerzeugung und -Auswertung mit Hilfe eines Mikrocomputers machen das erfindungsgemäße Impedanzmeßgerät besonders geeignet zur Bestimmung der durch Eintauchen in eine Flüssigkeit veränderlichen Impedanz eines kapazitiven Sensors, wie er in der internationalen Patentanmeldung WO-A-8 504 718 bzw. in der deutschen Patentanmeldung P 34 13 135.3 beschrieben ist. Es handelt sich dabei um einen Sensor, der in eine auf ihren Zustand zu überwachende Flüssigkeit eintaucht, wobei die Impedanz des Sensors durch die Flüssigkeit in Abhängigkeit von deren Zustand

EP 0 271 849 B1

verändert wird. Eine besonders vielversprechende Anwendung ist die Überwachung des Zustandes von Schmieröl in Verbrennungsmotoren. Verschlechtert sich der Zustand des Öls, so hat das Rückwirkungen auf die komplexe Dielektrizitätskonstante des Öls und damit auf die komplexe Impedanz des Sensors. Durch einen Vergleich mit Erfahrungswerten kann man aus der gemessenen Impedanz auf den Zustand des Öls zurückschließen und bei Überschreiten vorgebbarer Schwellenwerte der Impedanz geeignete Maßnahmen ergreifen, beispielsweise ein Warnsignal abgeben, welches anzeigt, dass das Öl gewechselt werden soll.

Zwei wesentliche Größen zur Beurteilung der Ölqualität bzw. Ölalterung sind die Alkalität und Viskosität des Öls. Vor allem, wenn man diese Größen nicht nur bei einer Temperatur überwacht (das europ. Patent 0 080 632 fordert z.B. dass die Ölqualtität nur bei betriebswarmem Motor überwacht wird), sondern über einen größeren Temperaturbereich kennt, also Kennlinien aufnimmt, die die Alkalität und die Viskosität in Abhängigkeit von der Temperatur zeigen und diese mit Meßwerten des Öles im Neuzustand vergleicht, so ist eine besonders aussagekräftige Beurteilung des Ölzustandes möglich. Die Meßwerte des Öles im Neuzustand kann man in einem Speicher der Auswerteschaltung des Impedanzmeßgerätes ablegen, so dass die aktuellen Meßwerte laufend mit den gespeicherten Meßwerten verglichen werden können.

Sind ein solcher kapazitiver Sensor und ein Temperaturfühler im Ölkreislauf eines Verbrennungsmotors installiert, so lassen sich, da nach dem Start des Motors zwangsläufig ein größerer Öltemperaturbereich durchfahren wird, bis der Motor betriebswarm ist, Meßwerte in Abhängigkeit von der Öltemperatur gewinnen. Dadurch, dass man Meßwerte bei unterschiedlichen Frequenzen des Meßsignales aufnimmt, kann man den Sensor auf unterschiedliche Eigenschaften der Flüssigkeit empfindlich machen. Bei welchen Frequenzen die Impedanzmessungen durchgeführt werden, richtet sich nach der Natur der Flüssigkeit, z.B. des Motoröls, und nach damit gewonnenen Erfahrungswerten. Vergleicht man die in Abhängigkeit von der Temperatur gewonnenen Meßwerte mit denen, die mit dem gleichen Öl im Neuzustand gewonnen und im Speicher der Auswerteschaltung (Mikrocomputer) abgelegt worden sind, so lassen sich aus der Änderung der Meßwerte und aus deren Verlauf über der Öltemperatur Aussagen über den Alterungszustand des Öles machen. Weiterhin können sogar aus der Art der Veränderungen der Öleigenschaften über der Temperatur Aussagen über die Ursachen bzw. über mögliche Schäden am Motor selbst gemacht werden.

Die Ergebnisse der Messungen bzw. ein Alarm bei Überschreiten von vorgebbaren Grenzwerten lassen sich mit Hilfe von an sich bekannten Anzeigegeräten, -Instrumenten oder Signalgebern zur Anzeige bringen. Zugleich können die Meßwerte aber auch im Speicher der Auswerteschaltung abgelegt und bei einer Wartung des Motors abgerufen werden. Diese abgerufenen Meßwerte können dann Hinweise auf erforderliche Wartungsarbeiten geben. Zwei Ausführungsbeispiele der Erfindung sind in den beigefügten Zeichnungen dargestellt.

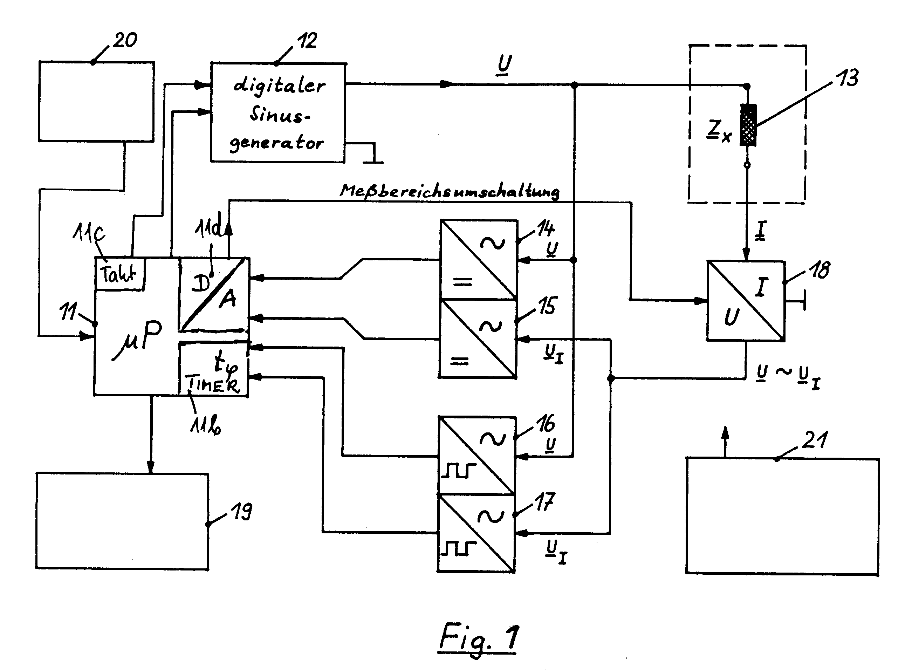

Figur 1  zeigt das Blockschaltbild einer ersten Ausführungsform eines Impedanzmeßgerätes,

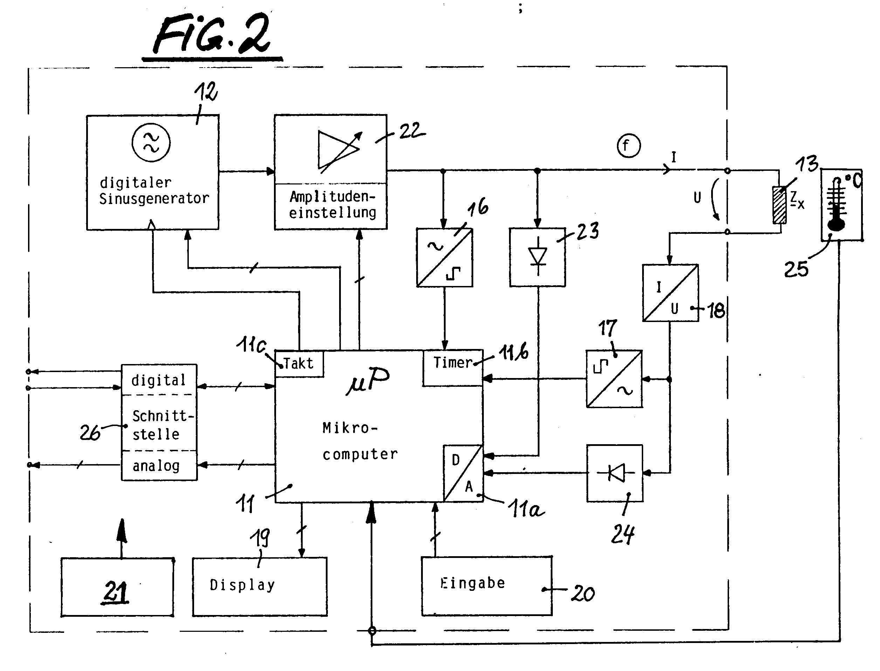

Figur 2  zeigt das Blockschaltbild einer zweiten Ausführungsform eines Impedanzmeßgerätes, und

Figur 3  zeigt das Blockschaltbild eines digitalen Sinusgenerators, der in beiden Ausführungsbeispielen zur Anwendung kommen kann.

Im ersten Ausführungsbeispiel steuert ein Mikroprozessor 11, bei dem es sich um den Typ SAB 80 515 handeln kann, einen digitalen Sinusgenerator 12. Der Mikroprozessor 11 und der digitale Sinusgenerator 12 sind durch einen gemeinsamen Takt synchronisiert, der von einem im Mikroprozessor 11 ausgebildeten Taktgeber 11c erzeugt wird. Der Sinusgenerator 12 liefert als Meßsignal eine sinusförmige Wechselspannung $\overline{U}$, welche einerseits dem Meßobjekt 13 Kapazitiver Sensor und andererseits einem ersten Wechselspannungs/Gleichspannungswandler 14 sowie einem ersten Nulldurchgangsdetektor 16 zugeführt wird. Das Meßobjekt 13 ist andererseits mit dem Eingang eines Strom/Spannungswandlers 18 verbunden, der den durch das Meßobjekt 13 fließenden Strom $\overline{I}$ in eine Wechselspannung $\overline{U_I}$ umwandelt, welche der Stromstärke des Wechselstroms $\overline{I}$ proportional ist. Der Ausgang des Strom/Spannungswandlers 18 ist einerseits mit einem zweiten Wechselspannungs/Gleichspannungswandler 15 und andererseits mit einem zweiten Nulldurchgangsdetektor 17 verbunden.

Die beiden Wechselspannungs/Gleichspannungswandler 14 und 15 wandeln die zugeführten Wechselspannungen $\overline{U}$ und $\overline{U_I}$ in Gleichspannungssignale um, deren Spannung den Amplituden $\hat{U}$ und $\hat{U_I}$ der Wechselspannungen $\overline{U}$ bzw. $\overline{U_I}$ proportional ist. Die beiden Gleichspannungen werden einem im Mikroprozessor 11 gebildeten Analog-zu-Digital-Wandler 11d mit zwei Analogeingängen zugeführt, welcher aus ihnen durch Verhältnisbildung die Wirkkomponente $R = \hat{U}/\hat{I}$ der Impedanz $Z_x$ des Meßobjekts 13 errechnet.

Die beiden Nulldurchgangsdetektoren 16 unf 17 erzeugen aus den zugeführten Wechselspannungen $\overline{U}$ und $\overline{U_I}$ Rechteckimpulsfolgen, deren Flanken zeitgleich mit den Nulldurchgängen der zugeführten Wechselspannungen $\overline{U}$ und $\overline{U_I}$ sind. Der Mikroprozessor 11 ermittelt daraus mittels einer Zählschaltung (Timer 11b) den zeitlichen Abstand $t_\phi$ zwischen den Nulldurchgängen des Wechselstroms $\overline{I}$ und der Wechselspannung $\overline{U}$ am Meßobjekt 13, errechnet daraus die Phasenverschiebung $\phi$ zwischen dem Wechselstrom $\overline{I}$ und der

4

Wechselspannung $\underline{U}$ und errechnet daraus ferner nach der Formel

$$\tan \phi = \tfrac{X}{R}$$

die Blindkomponente X der Impedanz des Meßobjektes 13.

Zur zahlenmässigen oder graphischen Darstellung des Meßergebnisses, z.B. zur Darstellung der Impedanz als Funktion der Frequenz, dient eine Anzeigeeinrichtung 19 (Display).

Dem Mikroprozessor 11 ist in diesem Beispiel ferner eine Eingabetastatur 20 zugeordnet, und dem Impedanzmeßgerät insgesamt eine Stromversorgungseinheit 21, bei der es sich um eine Batterie oder ein Netzteil handeln kann.

Es ist ferner eine Möglichkeit vorgesehen, über den Mikroprozessor 11 den Meßbereich des Strom/Spannungswandlers 18 umzuschalten.

Beim zweiten Ausführungsbeispiel ist der Schaltungsaufbau ähnlich dem im ersten Ausführungsbeispiel und deshalb sind gleiche oder einander entsprechende Schaltungsteile in den beiden Ausführungsbeispielen mit übereinstimmenden Bezugszahlen bezeichnet.

Auch im zweiten Ausführungsbeispiel steuert ein Mikroprozessor 11 einen digitalen Sinusgenerator, der mit dem Mikroprozessor 11 durch einen gemeinsamen Takt synchronisiert ist. Dem digitalen Sinusgenerator 12 ist ein steuerbarer Verstärker 22 nachgeschaltet, mit dessen Hilfe sich die Amplitude des sinusförmigen Meßsignals zur Meßbereichsanpassung einstellen läßt. Das so verstärkte Meßsignal wird wie im ersten Ausführungsbeispiel dem Meßobjekt 13 eingespeist, dessen Ausgang wie im ersten Ausführungsbeispiel mit dem Eingang eines Strom/Spannungswandlers 18 verbunden ist. Zur Ermittlung der Blindkomponente X der Impedanz des Meßobjektes sind wie im ersten Ausführungsbeispiel zwei Nulldurchgangsdetektoren 16 und 17 vorgesehen, mit deren Hilfe der zeitliche Abstand $t_\phi$ zwischen den Nulldurchgängen des Wechselstroms I und der Wechselspannung U am Meßobjekt 13 ermittelt wird.

Zur Ermittlung des Wirkwiderstandes R des Meßobjektes 13 sind jedoch anders als im ersten Ausführungsbeispiel keine Wechselspannungs/Gleichspannungswandler vorgesehen, vielmehr werden das Meßsignal durch einen Gleichrichter 23 und das Ausgangssignal des Strom/Spannungswandlers 18 durch einen Gleichrichter 24 gleichgerichtet und einem im Mikroprozessor 11 ausgebildeten schnellen Analog-zu-Digital-Wandler 11a zugeführt, der durch zeitgerechtes Abtasten die Spitzenwerte des Meßsignals und des Ausgangssignals des Strom/Spannungswandlers 18 direkt mißt; er kann dies, weil infolge der starren zeitlichen Kopplung zwischen dem Mikroprozessor 11 und dem digitalen Sinusgenerator 12 bekannt ist, wann die Spitzenwerte an den Eingängen des Analog-zu-Digital-Wandlers 11a erscheinen. Auf die Gleichrichter 23 und 24 kann verzichtet werden, wenn der Analog-zu-Digital-Wandler 11a nicht ausschließlich auf die Verarbeitung von Signalen einer Polarität ausgelegt ist, sondern auch Wechselspannungssignale verarbeiten kann.

Um Impedanzmessungen in Abhängigkeit von der Temperatur machen zu können, ist im zweiten Ausführungsbeispiel ferner ein Temperaturfühler 25 vorgesehen, der vom Mikroprozessor 11 zeitgleich mit den Impedanzmessungen abgefragt wird.

In einem Permanentspeicher des Mikroprozessors können zu vorgegebenen Temperaturen gehörende Vergleichswerte von Impedanzen abgelegt sein, mit denen der Mikroprozessor die aktuell gewonnenen Impedanzmeßwerte ständig vergleicht. Der Mikroprozessor 11 kann ferner dazu herangezogen werden, die gewonnenen Impedanzmeßwerte oder eine Auswahl davon für eine gewisse Zeit zu speichern, um sie innerhalb oder ausserhalb des Mikroprozessors nach vorgebbaren Kriterien auswerten zu können.

Zweckmässigerweise ist auch noch eine Schnittstelle 26 für die Kommunikation mit dem Mikroprozessor 11 vorgesehen.

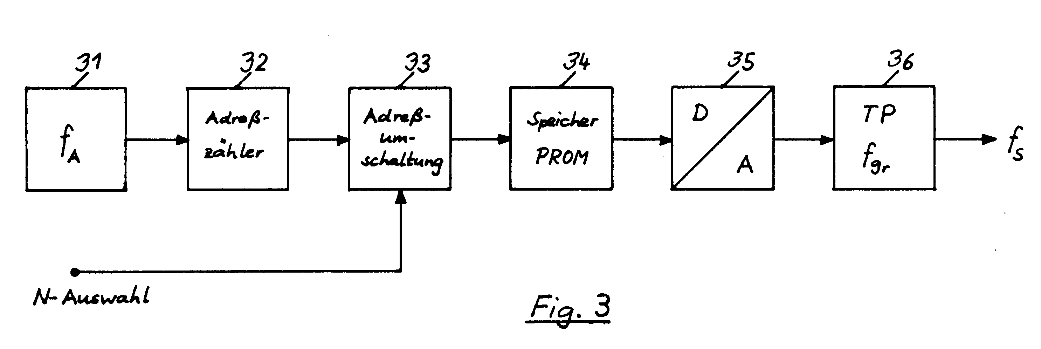

Das in Fig. 3 dargestellte Blockschaltbild eines digitalen Sinusgenerators zeigt einen abstimmbaren Oszillator 31, einen dem Oszillator nachgeschalteten Adreßzähler 32, eine dem Adreßzähler nachgeschaltete, steuerbare Adreßumschalteinrichtung 33, einen der Adreßschalteinrichtung nachgeschalteten, programmierbaren Speicher (PROM) 34, einen dem Speicher nachgeschalteten Digital-zu-Analog-Wandler 35 und einen diesem A/D-Wandler 35 nachgeschalteten Tiefpaßfilter 36.

In dem Speicher 34 werden die Momentanwerte für eine Sinussignalperiode mit maximaler Stützstellenzahl $N_o$ abgelegt. Es genügt jedoch auch, die Momentanwerte für nur eine halbe Periode abzulegen ( die Stützstellenzahl halbiert sich dann auf $N_o/2$) und für die zweite Halbperiode die der ersten Halbperiode zu verwenden und stattdessen das Vorzeichen des zu erzeugenden Sinussignals in der zweiten Halbperiode umzukehren.

Beim Betrieb des Sinusgenerators mit seiner niedrigsten Signalfrequenz (Grundfrequenz) $f_{min}$ wird der Adreßzähler 32 durch den Oszillator 31 mit einer Frequenz $f_{AO}$ getaktet und liest nacheinander sämtliche eingespeicherten Momentanwerte aus dem Speicher 34 in den Digital-zu-Analog-Wandler 35, welcher daraus eine der Sinusform stufenförmig angenäherte elektrische Schwingung bildet, welche durch das nachfolgende Tiefpaßfilter 36 geglättet wird.

Über die Adreßumschalteinrichtung 33 kann die Zuordnung zwischen dem Adreßzähler 32 und dem Speicher 34 geändert werden, so dass z.B. nur noch jeder 2., 3., 4., 5., ... Momentanwert, vorzugsweise nur noch jeder 2., 4., 8., 16., ... Momentanwert ausgelesen wird. Damit wird die Frequenz des erzeugten Sinussignals verdoppelt bzw. vervierfacht bzw. verachtfacht ... . Zugleich wird die Anzahl der für die Bildung des Sinussignals herangezogenen Stützstellen ausgehend von der maximalen Stützstellenzahl $N_o$ halbiert bzw. auf ein Viertel bzw. auf ein Achtel .... herabgesetzt.

Der Oszillator 31 ist so abstimmtar, dass er Abtastsignale mit Frequenzen $f_A \geq f_{AO}$ liefern kann. Die obere Grenzfrequenz des Oszillators 31 muss so hoch liegen, dass von einer diskreten Sinussignalfrequenz $n \cdot f_{min}$ bis zur nächst höheren diskreten Frequenz $(n+1) \cdot f_{min}$ ausgehend von der niedrigsten Abtastfrequenz $f_{AO}$ ein proportionaler Anstieg der Abtastfrequenz $f_A$ möglich ist. Für den bevorzugten Fall, dass n die Werte 2, 4, 8, 16, ... annimmt, muss der Frequenzbereich des Oszillators 1 von $f_{AO}$ bis $2f_{AO}$ reichen. Damit ist dann auch eine kontinuierliche Frequenzabstimmung des Sinusgenerators möglich.

Zur Illustration werden nachstehend noch Daten eines verwirklichten, digital gesteuerten Sinusgenerators angegeben:

Frequenzbereich des Sinusgenerators:

$f_{min}$ = 0,1 kHz

$f_{max}$ = 10 kHz

Abtastfrequenz: Von $f_{AO}$ = 50 kHz bis $f_{Amax}$ = 100 kHz

Maximale Zahl der Stützstellen: $N_o = 2^9 = 512$

Kleinste Zahl der Stützstellen: $N_{min} = 8 = 2^3$

Bereichsumschaltung gemäß $N = 2^k$, $3 \leq k \leq 9$

Die Frequenz des Sinussignals ergibt sich aus der Gleichung

$$f = f_A/N$$

Das Tiefpaßfilter hat eine Grenzfrequenz, welche zwischen der maximalen Frequenz des Sinussignals $f_{max}$ und der kleinsten Abtastfrequenz $f_{Amin}$ liegt, im gewählten Beispiel beträgt sie $f_{gr}$ = 12 kHz.

**Patentansprüche**

1. Impedanzmeßgerät zur Bestimmung der durch Eintauchen in eine Flüssigkeit, deren Zustand zu überwachen ist, veränderlichen Impedanz eines kapazitiven Sensors (13) mit einer Stromversorgungseinheit, mit einem Sinusgenerator (12) zum Erzeugen einer sinusförmigen elektrischen Wechselspannung als Meßsignal (U) mit Anschlußpunkten, über die das Meßsignal dem Sensor zugeführt werden kann, mit einer Auswerteschaltung, die das Meßsignal und das vom Sensor erhaltene elektrische Antwortsignal hinsichtlich Amplitude und Phasenlage miteinander vergleicht und daraus die Impedanz des kapazitiven Sensors ermittelt, wobei die Auswerteschaltung (11) einen Speicher enthält, in welchem Impedanzmeßwerte gespeichert sind, die mit der Flüssigkeit im Neuzustand ermittelt wurden, und die Auswerteschaltung (11) eine Vergleichsschaltung enthält, welche die gemessenen Impedanzwerte mit den zugehörigen Meßwerten im Neuzustand vergleicht und nach Überschreiten vorgebbarer Schwellenwerte ein Signal abgibt,

   dadurch gekennzeichnet, dass der Sinusgenerator (12) ein digitaler Sinusgenerator ist, der in einem Speicher (34) die Funktionswerte zu einer Anzahl von äquidistante Stützstellen für wenigstens eine Viertelwelle des sinusförmigen Signals gespeichert hat, sie in einem vorgegebenen Takt abruft und einem Digital-zu-Analog-Wandler (35) zuführt, der darauf ein durch einen Polygonzug der Sinusform angenähertes Wechselspannungssignal bildet,

   dass die Auswerteschaltung (11, 14 bis 17) eine digital arbeitende Meß- und Rechenschaltung (11), insbesondere einen Mikroprozessor, umfaßt, die durch ein gemeinsames Taktsignal mit dem Sinusgenerator (12) synchronisiert ist,

   dass ein Strom/Spannungswandler (18) vorgesehen ist, dem das Antwortsignal zugeführt wird und dessen Ausgangsspannung der Stromstärke des Antwortsignals proportional ist,

   dass eine Amplitudenauswerteschaltung (11a; 14, 15) vorgesehen ist, welche das Verhältnis der Amplitude des Meßsignals zur Amplitude des Ausgangssignals des Strom/Spannungswandlers (18) bildet und dadurch die Wirkkomponente der Impedanz des Sensors (13) bestimmt,

   und dass ein erster Nulldurchgangsdetektor (16) dem das Meßsignal zugeführt wird, sowie ein zweiter Nulldurchgangsdetektor (17), dem das Ausgangssignal des Strom/Spannungswandlers (18) zugeführt

## EP 0 271 849 B1

wird, vorgesehen sind, deren Ausgänge mit zwei Eingängen der Meß- und Rechenschaltung (11) verbunden sind, welche durch Messen des zeitlichen Abstands der beiden zugeführten Nulldurchgangssignale die Phasenverschiebung zwischen Strom und Spannung am Sensor (13) bestimmt und aus der Phasenverschiebung und der Wirkkomponente der Impedanz die Blindkomponente der Impedanz des Sensors (13) errechnet.

2. Impedanzmeßgerät nach Anspruch 1, dadurch gekennzeichnet, dass die Amplitudenauswerteschaltung (11a) ein schneller Analog/Digitalwandler (11a) mit zwei Analogeingängen als Teil der Meß- und Rechenschaltung (11) ist.

3. Impedanzmeßgerät nach Anspruch 2, dadurch gekennzeichnet, dass die Meß- und Rechenschaltung (11) mit dem Analog/Digitalwandler (11a) den Spitzenwert der den Analogeingängen des Analog/Digitalwandlers (11a) zugeführten Wechselspannungssignale oder einige dem Spitzenwert benachbarte Momentanwerte der Wechselspannungssignale abtastet und bis Bildung des Verhältnisses aus den Meßwerten der beiden Signale hält.

4. Impedanzmeßgerät nach Anspruch 2 oder 3, dadurch gekennzeichnet, dass die Meß- und Rechenschaltung (11) bei der Bestimmung der für die Ermittlung des Wirkwiderstandes erforderlichen Wechselspannungsamplituden eine der Wechselspannung eventuell über-lagerte Gleichspannung rechne-risch nach der Formel

$$\hat{U} = \frac{U_M}{1 - \sin\left(2\pi f\left(\frac{T}{4} - \frac{t}{2}1\right)\right)}$$

kompensiert, worin

$\hat{U}$ die gesuchte Amplitude der reinen Wechselspannung,
$U_M$ der gemessene Spitzenwert,
f die bekannte Frequenz des Meßsignals,
T die Periode des Meßsignals, und
$t_1$ der gemessene zeitliche Abstand zwischen zwei aufeinanderfolgenden Nulldurchgängen des Wechselspannungssignals ist, zwischen denen der gemessene Spitzenwert $U_M$ liegt.

5. Impedanzmessgerät nach Anspruch 1, dadurch gekennzeichnet, dass die Amplitudenauswerteschaltung (11, 14, 15) einen ersten Wechselspannungs/Gleichspannungswandler (14), dem das Meßsignal zugeführt wird, und einen zweiten Wechselspannungs/Gleichspannungswandler (15), dem das Ausgangssignal des Strom/Spannungswandlers (18) zugeführt wird, sowie einen Analog/Digitalwandler (11d) mit zwei Analogeingängen als Teil der Meß- und Rechenschaltung (11) umfaßt, wobei der Analog/Digitalwandler (11d) das Verhältnis der beiden ihm von den Wechselspannungs/Gleichspannungswandlern (14, 15) zugeführten Gleichspannungswerte bestimmt.

6. Impedanzmeßgerät nach Anspruch 1, dadurch gekennzeichnet, dass auch aktuelle Impedanzmeßwerte im Speicher für eine spätere Auswertung gespeichert werden.

7. Impedanzmeßgerät nach Anspruch 1 oder 8, dadurch gekennzeichnet, dass zusätzlich ein Temperaturfühler (25) für die Bestimmung der Temperatur des Sensors (13) vorgesehen ist und dass im Speicher Impedanzmeßwerte in Abhängigkeit von der Temperatur gespeichert sind.

**Claims**

1. An impedance measuring device to determine the change of the impedance of a capacitive sensor (13) caused by dipping it into a fluid of which the state must be monitored, comprising a power supply unit, a sine wave generator (12) to produce a sinusoidal alternating voltage as test signal (U) that is provided with terminals over which the test signal can be sent to the sensor, an evaluating circuit, that compares the amplitude and the phase position of the test signal with those of the electric response signal

7

received from the sensor and determines therefrom the impedance of the capacitive sensor, the evaluating circuit (11) of which includes a memory that stores the impedance readings obtained with the fluid in the new state, and wherein the evaluating circuit (11) includes a comparator circuit that compares the measured impedance readings with the thereto corresponding readings of the new state and emits a signal, after exceeding threshold values that can be preset,

characterized in that the sine wave generator (12) is a digital sine wave generator, that stores in a memory (34) the operational values for a number of equidistant restart points for at least a quarter-wave of the sinusoidal signal, fetching them at a preset cycle and feeding them to a digital-to analog converter (35), that thereupon forms over a polygonal course a roughly sinusoidal alternating voltage signal,

that the evaluating circuit (11, 14 to 17) includes a numerically operated measuring and computing circuit (11), in particular a microprocessor, that is synchronized with the sine wave generator (12) by means of a common timing signal,

that there is provided a voltage-current converter (18), to which is sent the response signal whose output voltage is proportional to the amperage of the response signal,

that an amplitude evaluating circuit (11a; 14, 15) is provided, that forms the ratio of the test signal's amplitude to the amplitude of the voltage-current converter's (18) output signal, thus determining the active component of the sensor's (13) impedance and that there are provided a first crossover sensor (16) to which is sent the test signal, as well as a second crossover sensor (17) to which is sent the output signal of the voltage-current converter (18), whose outputs are connected to two inputs of the measuring and computing circuit (11), that, by measuring the time interval of the two imparted crossover signals, determines the phase displacement between current and voltage at the sensor (13) and, on basis of the phase displacement and the active component of the impedance, calculates the reactive component of the sensor's (13) impedance.

2. An impedance measuring device according to claim 1 characterized in that the amplitude evaluating circuit (11a) is a rapid analog-to-digital converter (11a) provided with two analog inputs as part of the measuring and computing circuit (11).

3. An impedance measuring device according to claim 2 characterized in that the measuring and computing circuit (11) with the analog-to-digital converter (11a) samples the peak value of the alternating volta signals sent to the analog inputs of the analog-to-digital converter (11a), or some of the transient values of the alternating voltage signals, said transient values being close to the peak values, holding that peak value until forming the ratio from the test values of both values.

4. An impedance measuring device according to claim 2 or 3 characterized in that the measuring and computing circuit (11), when determining the alternating voltage amplitudes, necessary for the finding of the active resistance, mathematically compensates a direct voltage, possibly superimposed on the alternating voltage, by means of the formula

$$\hat{U} = \frac{U_M}{1 - \sin\left(2\pi f\left(\frac{T}{4} - \frac{t}{2}1\right)\right)}$$

where

$\hat{U}$     is the required amplitude of the true alternating voltage

$U_M$     is the measured peak value

$f$     is the known frequency of the test signal

$T$     is the cycle of the test signal, and

$t_1$     is the measured time interval between two successive crossovers of the alternating voltage signal, between which lies the measured peak value $U_M$.

5. An impedance measuring device according to claim 1 characterized in that the amplitude evaluating circuit (11, 14, 15) includes a first alternating voltage/direct voltage converter (14), to which is sent the test signal, a second alternating voltage/direct voltage converter (15), to which is sent the output signal of the voltage-current converter (18), as well as an analog-to-digital converter (11d) with two analog inputs as part of the measuring and computing circuit (11), wherein the analog-to-digital converter (11d) determines the ratio of the two direct voltage values fed to it by the alternating voltage/direct voltage converters (14, 15).

6. An impedance measuring device according to claim 1 characterized in that also actual impedance test values are stored in the memory for a future evaluation.

7. An impedance measuring devise according to claim 1 or 8 characterized in that additionally there is provided a temperature probe (25) to determine the temperature of the sensor (13), and wherein impedance test values are stored in the memory in dependence on the temperature.

**Revendications**

1. Appareil de mesure d'impédance pour la détermination de l'impédance d'un détecteur capacitif (13) qui varie par immersion dans un liquide dont il faut contrôler l'état, comprenant un groupe d'alimentation en courant, un générateur (12) destiné à produire une tension alternative électrique sinusoïdale (U), des points de connexion par lesquels le signal de mesure peut être envoyé au détecteur, un circuit d'analyse qui compare l'amplitude et le phasage du signal de mesure et ceux du signal électrique de réponse obtenu du détecteur et qui détermine par cette amplitude et ce phasage l'impédance du détecteur capacitif, le circuit d'analyse (11) contenant une mémoire dans laquelle sont mémorisées les mesures d'impédance qui ont été déterminées avec le liquide à un nouvel état et le circuit d'analyse (11) comprenant un circuit comparateur qui compare les impédances mesurées aux mesures correspondant au nouvel état et qui émet un signal en cas de dépassement de seuils prescrits, caractérisé en ce que le générateur (12) d'une tension sinusoïdale est un générateur numérique qui a mémorisé dans une mémoire (34) les valeurs de la fonction en de multiples points équidistants fixes d'au moins un quart d'onde du signal sinusoïdal, qui les extrait à une cadence prescrite et les envoie à un convertisseur numérique-analogique (35) qui en forme un signal en tension alternative qui est une approximation en un tracé polygonal de la forme sinusoïdale,
en ce que le circuit d'analyse (11, 14 à 17) comprend un circuit de mesure et de calcul (11) opérant par voie numérique, en particulier un microprocesseur qu'un signal d'horloge commun synchronise avec le générateur de tension sinusoïdale (12),
en ce qu'un convertisseur de courant en tension (18), auquel le signal de réponse est envoyé et dont la tension de sortie est proportionnelle à l'intensité du courant du signal de réponse, est prévu,
en ce qu'un circuit d'analyse d'amplitude (11a ; 14, 15) est prévu et forme le rapport de l'amplitude du signal de mesure à l'amplitude du signal de sortie du convertisseur de courant en tension (18) et en détermine la composante active de l'impédance du détecteur (13)
et en ce qu'un premier détecteur de passage par zéro (16), auquel le signal de mesure est envoyé, ainsi qu'un second détecteur de passage par zéro (7), auquel le signal de sortie du convertisseur du courant en tension (18) est envoyé, sont prévus, leurs sorties étant connectées à deux entrées du circuit de mesure et de calcul (11) qui détermine le déphasage entre le courant et la tension que reçoit le détecteur (13) par la mesure de l'intervalle de temps séparant les deux signaux reçus de passage par zéro et qui calcule à l'aide du déphasage et de la composante active de l'impédance la composante réactive de l'impédance du détecteur (13).

2. Appareil de mesure d'impédance selon la revendication 1, caractérisé en ce que le circuit d'analyse d'amplitude (11a) est un convertisseur analogique-numérique rapide (11a) comprenant deux entrées analogiques faisant partie du circuit de mesure et de calcul (11).

3. Appareil de mesure d'impédance selon la revendication 2, caractérisé en ce que le circuit de mesure et de calcul (11) explore à l'aide du convertisseur analogique-numérique (11a) la valeur de pointe des signaux en tension alternative envoyés aux entrées analogiques du convertisseur analogique-numérique (11a) ou de quelques valeurs momentanées des signaux en tension alternative qui sont voisines de la valeur de pointe et les conserve jusqu'à la formation du rapport des mesures de deux signaux.

4. Appareil de mesure d'impédance selon la revendication 2 ou 3, caractérisé en ce que le circuit de mesure et de calcul (11) compense par calcul, lors de la détermination des amplitudes de tension alternative qui sont nécessaires à la détermination de la résistance active, une tension continue éventuellement superposée à la tension alternative d'après la formule

$$\hat{U} = \frac{U_M}{1 - \sin\left(2\pi f\left(\frac{T}{4} - \frac{t_1}{2}\right)\right)}$$

formule dans laquelle

$\hat{U}$ est l'amplitude cherchée de la tension alternative pure,

$U_M$ est la valeur de pointe mesurée,

f est la fréquence connue du signal de mesure,

T est la période du signal de mesure et

$t_1$ est l'intervalle de temps mesuré entre deux passages successifs par zéro du signal en tension alternative entre lesquels se trouve la valeur de pointe mesurée $U_M$.

5. Appareil de mesure d'impédance selon la revendication 1, caractérisé en ce que le circuit d'analyse d'amplitude (11, 14, 15) comprend un premier convertisseur de tension alternative en tension continue (14) auquel le signal de mesure est envoyé, ainsi qu'un second convertisseur de tension alternative en tension continue (15) auquel le signal de sortie du convertisseur de courant en tension (18) est envoyé, ainsi qu'un convertisseur analogique-numérique (11d) comprenant deux entrées analogiques faisant partie du circuit de mesure et de calcul (11), le convertisseur analogique-numérique (11d) déterminant le rapport des deux tensions continues qui lui sont envoyées par les convertisseurs (14, 15) de tension alternative en tension continue.

6. Appareil de mesure d'impédance selon la revendication 1, caractérisé en ce que les mesures réelles d'impédance sont aussi mémorisées dans la mémoire pour une analyse ultérieure.

7. Appareil de mesure d'impédance selon la revendication 1 ou 6, caractérisée en ce qu'il comprend en plus un détecteur de température (25) pour la détermination de la température du détecteur (13) et en ce que des mesures d'impédance sont mémorisées dans la mémoire en fonction de la température.

Fig. 1

EP 0 271 849 B1

**FiG.2**

| 31 | | 32 | | 33 | | 34 | | 35 | | 36 | |
|---|---|---|---|---|---|---|---|---|---|---|---|
| $f_A$ | → | Adreß-zähler | → | Adreß-um-schaltung | → | Speicher PROM | → | D / A | → | TP $f_{gr}$ | → $f_s$ |

N-Auswahl

$\underline{Fig.\ 3}$